# EUROPEAN PATENT APPLICATION

(11) **EP 1 722 006 A1**
(43) Date of publication of application: **15.11.2006**
(21) Application number: 05103894.1
(22) Date of filing: 10.05.2005
(51) Int. Cl.: C23C 16/04, C23C 16/505, C23C 14/04, C23C 28/00, B05D 7/22

(54) **Method for the anticorrosion surface treatment of containers for fluids, container provided by means of the method, and apparatus for performing the method**

(71) Applicant: S.I.C.C. Societa' Per Azioni, 45100 Rovigo (IT)
(72) Inventor: Ghinatti, Gabriele, 45031, Arqua' Polesine RO (IT)
(74) Representative: Modiano, Micaela Nadia

(57) **Abstract**

A method for the anticorrosion surface treatment of containers for fluids, which consists in depositing at least one anticorrosion protective layer on the internal surface (11) of a container (10) for fluids. The deposition of at least one anticorrosion protective layer is provided by plasma deposition, by using the container as a reaction chamber.

## Description

The present invention relates to a method for the anticorrosion surface treatment of containers for fluids, useful particularly but not exclusively in the case of tanks for generating sanitary hot or cold water and the like.

The present invention also relates to a container for fluids, such as for example a tank for generating sanitary hot or cold water, that is provided by means of such method; the container may also be provided for gaseous fluids such as air, nitrogen and the like.

The invention also relates to an apparatus for performing a method for the anticorrosion surface treatment of containers for fluids.

Currently, in the manufacture of containers for fluids, such as for example sanitary hot water heaters, boilers, tanks for sanitary cold water, but also tanks for other applications, it is necessary to provide an internal coating in order to avoid corrosion phenomena: said containers are in fact generally made of steel and rust when in contact with water (rust formation times vary depending on the materials used, on the surface treatments used and on the type of application of said container).

Problems in terms of "corrosion" attacks can also occur with particular liquids or gaseous fluids (air, nitrogen, etc).

Considering for example the case of containers/tanks for sanitary water, the formation of rust releases into the water accumulated in the container "ferrous" particles that cause "pollution" and further shortens considerably the life of the container.

In order to reduce the problem of corrosion, two separate anticorrosion treatments are substantially performed inside the containers: coating with thermoplastic and thermosetting powders, and coating with enamels having a high melting point.

Although these treatments extend the life of the container with respect to corrosion, they do not solve the problem drastically and in fact reveal significant limitations.

For example, coating with thermoplastic and thermosetting powders has limited adhesion of the coating layer, low uniformity of its thickness, and poor protection in the corners and edges of the container; moreover, a cathodic protection effect causes blistering phenomena (due to the anode consumption of magnesium) and subsequent detaching of the coating.

Coating with enamels having a high melting point instead has limitations in terms of rigidity and brittleness of the coating, formation of microcracks at high temperature and, as an important aspect, a high complexity of the anticorrosion treatment apparatus.

The aim of the present invention is to provide a method for the anticorrosion surface treatment of containers for fluids that solves the problems noted in known kinds of container for fluids.

Within this aim, an object of the present invention is to provide a method for the anticorrosion surface treatment of containers for fluids that increases the life of said containers.

Another object of the present invention is to provide a method for the anticorrosion surface treatment of containers for fluids that allows to obtain, inside the treated container, uniformity of the thickness of the coating and high adhesion to the walls.

Another object of the present invention is to provide a method for the anticorrosion surface treatment of containers for fluids that allows to obtain, for the coating, an optimum resistance to high temperatures and thermal variations.

Another object of the present invention is to provide a method for the anticorrosion surface treatment of containers for fluids that allows resistance to corrosion in various aqueous environments.

This aim and these and other objects that will become better apparent hereinafter are achieved by a method for the anticorrosion surface treatment of containers for fluids, which consists in depositing at least one anticorrosion protective layer on the internal surface of a container for fluids, the deposition of at least one of said at least one anticorrosion protective layer being provided by plasma deposition, by using the container itself as a reaction chamber.

Advantageously, the invention also comprises a container for fluids, characterized in that it comprises, directly in contact with its internal walls, a layer of plasma-deposited material.

Further characteristics and advantages of the method according to the invention will become better apparent from the following detailed description of a preferred but not exclusive embodiment thereof, described hereinafter by way of non-limiting example; characteristics and advantages will also become apparent from the description of a preferred but not exclusive embodiment of an apparatus for performing said method and of a container treated with said method, illustrated by way of example in the accompanying drawings, wherein:
Figure 1 is a schematic view of an apparatus for performing a method according to the invention;
Figures 2a, 2b, 2c, 2d, 2e are views of alternative portions of the cross-section of a container that has been treated on its surface with the method according to the invention;
Figure 3 is a view of another embodiment of a portion of the cross-section of a container that has been treated on its surface with the method according to the invention.

The method for the anticorrosion surface treatment of containers for fluids according to the invention consists mainly in depositing a layer of material, for example quartz-based material (quartz) or of the silicone type, on the internal surface of a container for fluids, such as for example a generator of sanitary cold or hot water made substantially of steel.

The optimum provision of said layer is substantial in order to obtain an anticorrosion coating.

For this reason, the deposition of said quartz- or silicone-based layer is performed by plasma deposition, the operation of which is now known; for example, plasma deposition of the PECVD (Plasma Enhanced Chemical Vapor Deposition) type is used.

As it is known, in a plasma process, in order to obtain a coating on an object, a gaseous or vaporised precursor compound is introduced in a reaction chamber at a very low pressure (in vacuum conditions).

The precursor is typically made to react in its pure state by using a gas, such as for example oxygen.

A plasma condition is generated by energizing the precursor inside the reaction chamber by generating an electrical field.

The result is an ultrathin clinging layer of material, derived from the precursor, which is deposited on the entire free surface of any object introduced in the reaction chamber and also on the free surface of said reaction chamber.

The process for forming the material that is deposited by way of the plasma transformation of the precursor that reacts with the reaction gas is started and performed by means of an electrical field so as to reach the breakdown of the precursor of the deposition layer inside the reaction chamber.

Once breakdown has occurred, ions and reactive species are formed and begin and continue the atomic and molecular reactions that lead to the formation of thin films.

The generation of the electrical field occurs by way of an antenna, which acts as a cathode and is inserted in the reaction chamber, which acts as an electrode; a radiofrequency electric power supply is applied to said antenna.

It is evident that, as in the preceding case, by introducing a substantially closed container in a reaction chamber for plasma deposition, the walls that are coated are the external walls of said container.

Advantageously, instead, the invention uses the container as a reaction chamber, thus achieving the deposition of the quartz- or silicone-based material on the entire internal surface of said container.

The method further provides for the possibility to deposit additional layers on the first plasma-deposited layer.

For example, the method provides for a deposition of a layer of metallic material, for example by metallic evaporation, particularly by means of the technology known as "magnetron sputtering" or by means of a generic Joule effect, both of which are per se known.

The method also provides for the optional deposition of a layer of paint, for example by means of a method such as magnetron sputtering or a Joule effect.

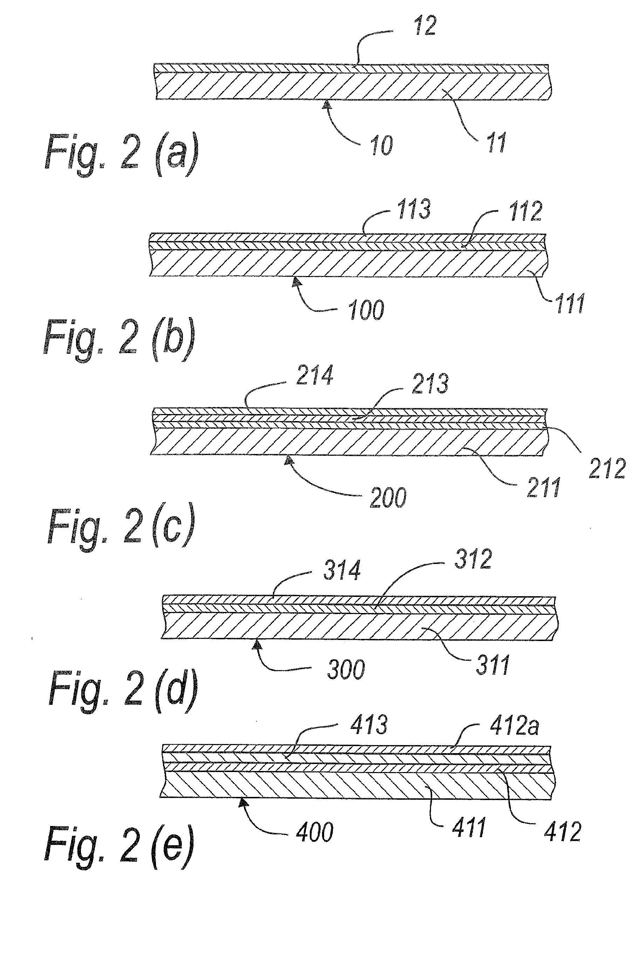

Figures 2a to 2e illustrate five examples of portions of cross-section of a container generally designated by the reference numeral 10, the walls of which, designated by the reference numeral 11, are coated by layers that are deposited according to steps of the method described above (the relative dimensions of the layers are not real but merely examples).

In particular, Figure 2a illustrates the wall 11 of the container 10, which is coated internally by a layer of quartz-based material (substantially quartz) 12 by way of a plasma deposition as mentioned above.

Figure 2b illustrates the wall 111 of the container 100, which is coated internally by a first plasma-deposited layer 112, for example made of quartz-based material, on which an additional layer is deposited by way of a deposition of metallic material 113, such as for example gold.

Figure 2c illustrates the wall 211 of the container 200, which is coated internally with a first plasma-deposited layer 212, made for example of quartz-based material, on which a layer is deposited by means of a deposition of metallic material 213; an additional layer of paint 214, for example polyester-based paint, is then deposited on said layer.

Figure 2d illustrates the wall 311 of the container 300, coated internally with a first plasma-deposited layer 312, made for example of quartz-based material, on which a layer of paint 314, for example polyester-based paint, is deposited.

Figure 2e illustrates the wall 411 of the container 400, which is coated internally by a first plasma-deposited layer 412, for example made of quartz-based material, on which a layer is deposited by deposition of metallic material 413, such as for example stainless steel; an additional plasma-deposited layer 412a, made of quartz- or silicone-based material, is then deposited on said layer.

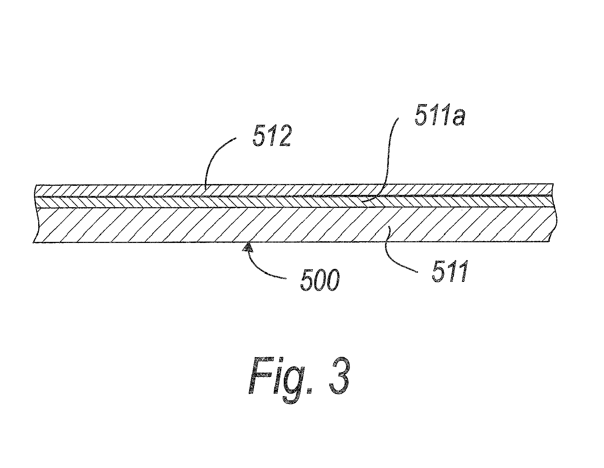

Figure 3 illustrates a different embodiment of a container, designated by the reference numeral 500, in which the first deposited layer is metallic (designated by the numeral 511), for example stainless steel deposited with a Joule-effect or magnetron-sputtering technology or in any case with another technology for metalization by evaporation.

In this case, the deposition method provides for depositing on the wall 511 of the container 500 a first metallic layer 511 a and subsequently depositing a plasma-deposited layer 512, for example in the manners described earlier.

It is subsequently possible to deposit additional protective layers, as described in the above examples.

The above examples can of course consider different materials, such as for example the ones listed hereafter.

The plasma-deposited materials are preferably quartzes and silicones, as already mentioned.

The precursors in plasma deposition for these materials are substantially siloxanes; for example, hexamethyldisiloxane is used for the plasma deposition of quartzes.

The metallic materials deposited by so-called "evaporative metalization" are preferably aluminum, silver, gold, platinum, titanium, palladium, alumina oxide, stainless steel, ceramic materials (such as for example Macor^{(R)}, the commercial name of a ceramic material of the British company Coming).

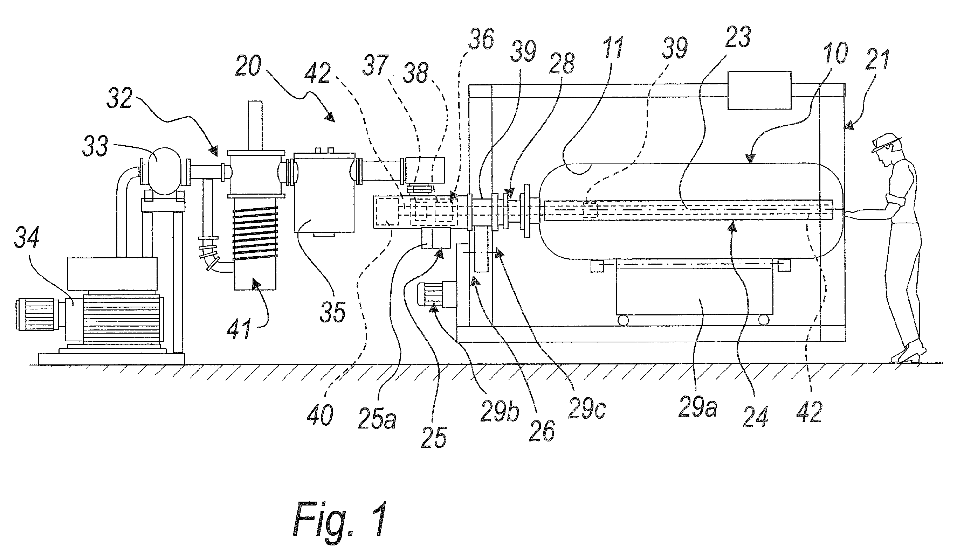

Figure 1 is a diagram of an apparatus for performing an anticorrosion surface treatment method for containers for fluids, generally designated by the reference numeral 20.

The apparatus 20 comprises a supporting framework 21 for the container 10 to be treated on the internal side of the walls 11 as described above.

The container 10 is for example a tank of a sanitary water generating unit, which has, at one end, a single port 22, which is coaxial to the main axis 23 of the container 10.

Inside the container 10 there is an antenna 24, which acts as a cathode for a device for generating plasma, designated schematically by the reference numeral 25 and described hereinafter.

The apparatus 20 comprises means 26 for relative rotation between the antenna 24 and the container 10.

In this embodiment, the relative rotation means 26 are constituted by rotation means 27, described hereinafter, for the rotation of the container 10 about the main axis 23.

The port 22 is connected, by means of flanges 28, to a collar 29, which is fixed to the framework 21 and allows, for example by means of a system of sliding gaskets (not shown in the figures), a rotary connection to the container 10.

In this embodiment, the container 10 is arranged horizontally and is supported by a lower supporting trolley 29a; in particular, it rests on free rollers (not shown), which allow it to rotate about its main axis.

The rotation means 27 are constituted by a motor drive 29b, which is kinematically connected for example by means of a toothed coupling 29c to the region of the flanges 28.

The plasma generation device 25 mentioned earlier comprises a radiofrequency generator 25a (for example at 13.56 MHz), with automatic impedance adjustment, which allows to maximize the energy transferred to the process atmosphere.

The radiofrequency generator is for example an Advance Energy model with a power of 3 kW, provided with a control system or tuner.

As mentioned, the container 10 acts as a reaction chamber inside which the antenna-cathode 24 is arranged.

The antenna 24 is slightly shorter than the internal axial length of the container 10.

In order to cause plasma deposition, it is necessary to provide substantially a vacuum in the reaction chamber and therefore inside the container 10.

A vacuum generation device is therefore connected to said container and comprises pumping means 32, which are functionally connected to the port 22 of the container 10.

The pumping means 32 comprise, respectively in series, a first suction pump 33, for example of the so-called Roots type, with a nominal capacity that can vary from approximately 200 m²/h to approximately 2000 m²/h, which is functionally connected to the port 22, and a second suction pump 34, for example a mechanical rotary piston pump, with a nominal capacity of 250 m²/h.

Between the port 22 and the first suction pump 33 there is a cryogenic trap 35, of a per se known type, which allows to retain any process waste which, in a prolonged use typical of an industrial application, might damage the pumps.

The apparatus 20 also comprises a device for treating the process gas, designated schematically by the reference numeral 36, which allows to control the quality of the PECVD plasma deposition.

The process gas treatment device 36 comprises two electronically controlled MKS flowmeters, respectively a first flowmeter 37 and a second flowmeter 38, each of which is arranged on the respective connection channel for the gas (for example oxygen) for reaction with the precursor, and for the precursor itself (for example hexamethyldisiloxane).

The adjustment of the flowmeters 37 and 38 allows to modify the absolute quantity of gas-vapor to be introduced in the reaction chamber/container 10 and to modify the relative composition.

The process gas treatment device 36 further comprises an active pressure measurement head, shown schematically inside the container 10 by means of the reference numeral 39, for example of the Leybold Pirani-Penning type, which allows to control the pressure of the process atmosphere, an important parameter for determining the characteristics of the coating.

One example of a plasma deposition process with an apparatus 20 thus described is as follows.

First of all, the first suction pump 33 and the second suction pump 34 are started in order to evacuate the air inside the container 10 and provide the process atmosphere for PECVD plasma deposition.

Once a vacuum on the order of 10⁻¹ mbar has been reached, the plasma generation device 25 is activated.

Then, by using the control system, the flowmeters that determine the amounts of precursor and reagent gas that will be introduced in the chamber are set.

Hexamethyldisiloxane is used as a precursor for quartz deposition and oxygen is used as a reaction gas.

Once the flowmeters have been set, the valves of the flowmeters related to the precursor and to the oxygen are opened. The vapors of the precursor and the oxygen are thus introduced in the reaction chamber/container 10 through the antenna 24 and are deposited on the internal walls of the container 10.

The walls of the container 10 and the precursor are kept at ambient temperature (20-30 °C).

By performing deposition for variable times (for example 2 and 6 minutes), different thicknesses are obtained (respectively 0.01 µm and 1 µm).

By using hexamethyldisiloxane as a precursor, a quartz coating film is formed.

The state of the film can be checked by virtue of SEM and AFM (Secondary Electron Microscopy and Atomic Force Microscopy) surface measurements, in order to verify the structure, and by means of XPS (Photoelectron X-ray Spectroscopy) measurements to check the uniformity of the coating and the chemical composition (SiO₂).

Once deposition has ended, the valves of the flowmeters are closed and the plasma generator 25 is switched off.

The apparatus 10 also comprises a device for the deposition of metals by evaporation (metalization) 40.

Said metal deposition device, schematically designated by the reference numeral 40, is for example of the sputter magnetron type for evaporating metals in general, of a per se known type.

The magnetron sputtering deposition technique is a vacuum deposition of metals in gas form, which are conveyed by means of carrier gases.

The vacuum pressure of the reaction chamber/container 10 is approximately 5x10⁻² mbars after reaching a vacuum of less than 10⁻³ mbars by introducing carrier gases equal to 5x10⁻² mbars.

The metal deposition device 40 integrates in the antenna 24 the channel for conveying the metal in gaseous form 42.

This deposition technique is very clean, and therefore the adhesion of the material on the different material is extremely durable.

The materials that can be deposited are various (silver, gold, stainless steel, nickel chrome, etc) and therefore there are various coating possibilities.

For the magnetron sputtering deposition technique, it is substantial to control the (very high) vacuum in the reaction chamber/container 10.

For this reason, the apparatus 10 comprises a third suction pump 41, for example of the diffusion type with a nominal capacity of 8000 l/s, which is arranged between the first suction pump 33 and the cryogenic trap 35.

For the metalization step, after the plasma deposition step, the third suction pump 41 is switched on to generate the atmosphere required for the deposition of metals and steels over the quartz layer.

The antenna 24 can be telescopic in order to facilitate the insertion of the container 10.

Both during plasma deposition and during metalization or coating, the container 10 is turned by way of the rotation means 27.

In this manner, the entire internal surface of the container 10 passes in front of the regions of the antenna 24 from which the oxygen and the precursor and the vaporised metal exit, achieving a uniform deposition on all of said container.

It is evident that the same result can be achieved by turning the antenna with respect to the container.

In practice it has been found that the invention thus described solves the problems noted in known types of container for fluids; in particular, the present invention provides a method for anticorrosion surface treatment of containers for fluids that extends considerably the life of said containers.

With said method and the corresponding apparatus for execution, it is in fact possible to deposit coating layers that have a uniform thickness and a very high adhesion to the walls and to achieve excellent resistance to high temperatures and to heat variations and a high resistance to corrosion in various aqueous environments (by way of the great variety of materials that can be deposited).

The optimum properties are achieved with a plasma-deposited layer, since the nanophase properties of the material thus deposited are able to provide an extremely high quality of the adhesion to the underlying adjacent material.

Advantageously, the container has also been used as a chamber for depositing metallic layers or coating products according to evaporative deposition techniques such as magnetron sputtering or generic Joule effect, by using, in order to form the vacuum, also part of the device for the vacuum of the plasma deposition.

The invention thus conceived is susceptible of numerous modifications and variations, all of which are within the scope of the appended claims; all the details may further be replaced with other technically equivalent elements.

In practice, the materials employed, so long as they are compatible with the specific use, as well as the dimensions, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A method for the anticorrosion surface treatment of containers for fluids, which consists in depositing at least one anticorrosion protective layer on the internal surface of a container for fluids, the deposition of at least one of said at least one anticorrosion protective layer being provided by plasma deposition, by using the container as a reaction chamber.

2. The method according to claim 1, **characterized in that** said plasma deposition is of the PECVD (Plasma Enhanced Chemical Vapor Deposition) type.

3. The method according to claim 2, **characterized in that** the plasma deposition is performed by using a plasma generation device (25) which comprises a radiofrequency generator (25a), which is associated with an antenna (24), which acts as a cathode and is inserted in said container (10), which acts as a reaction chamber, the precursor material of the deposition and the reagent gas with said precursor flowing out from said antenna (24), said antenna (24) and said container (10) rotating with respect to each other during said plasma deposition step.

4. The method according to claim 3, **characterized in that** the precursor of material in the plasma deposition is hexamethyldisiloxane.

5. The method according to claim 1, **characterized in that** it comprises the deposition, by evaporative deposition, of at least one layer of metallic material.

6. The method according to claim 5, **characterized in that** said evaporative deposition occurs by means of a Joule effect.

7. The method according to claim 6, **characterized in that** said evaporative deposition occurs by means of magnetron sputtering technology.

8. The method according to one or more of the preceding claims, **characterized in that** it comprises the deposition of at least one layer of paint.

9. The method according to one or more of the preceding claims, **characterized in that** it comprises the deposition of at least one layer of quartz-based material.

10. The method according to one or more of the preceding claims, **characterized in that** the plasma-deposited anticorrosion protective layer is a quartz-based material.

11. The method according to one or more of the preceding claims, **characterized in that** the plasma-deposited anticorrosion protective layer is a silicone-based material.

12. The method according to one or more of the preceding claims, **characterized in that** the materials of the layers deposited by evaporation are chosen preferably among aluminum, silver, gold, platinum, titanium, palladium, alumina oxide, stainless steel, and ceramic materials.

13. The method according to one or more of the preceding claims, **characterized in that** the first layer of said anticorrosion protective layer is deposited by plasma deposition.

14. The method according to one or more of claims 1 to 12, **characterized in that** the first layer of said anticorrosion protective layer is deposited by evaporative deposition.

15. A container for fluids, **characterized in that** it comprises, directly in contact with its internal walls, a layer of plasma-deposited material (12, 112, 212, 312, 412).

16. A container for fluids, **characterized in that** it comprises, directly in contact with its internal walls, a first deposition layer of metallic material (511a) and, thereon, a layer of plasma-deposited material (512).

17. A container for fluids according to claim 15 or 16, **characterized in that** said plasma-deposited material (12, 112, 212, 312, 412, 512) is chosen among quartzes or silicones.

18. A container for fluids according to claim 15, **characterized in that** it comprises, in contact with said layer of plasma-deposited material (112, 212), an additional deposition layer of metallic material (113, 213).

19. A container for fluids according to claim 18, **characterized in that** it comprises, in contact with said deposition layer of metallic material (213), a layer of paint (214).

20. A container for fluids according to claim 18, **characterized in that** it comprises, in contact with said deposition layer of metallic material (413), an additional plasma-deposited layer (412a).

21. A container for fluids according to claim 15, **characterized in that** it comprises, in contact with said layer of plasma-deposited material (312), a layer of paint (314).

22. A container for fluids according to claim 19 or 21, **characterized in that** said paint is polyester-based.

23. A container for fluids according to one or more of claims 18 to 20, **characterized in that** the metallic material of said deposition layer of metallic material is preferably chosen among aluminum, silver, gold, platinum, titanium, palladium, alumina oxide, stainless steel, and ceramic materials.

24. An apparatus for performing a method for the anticorrosion surface treatment of containers for fluids according to one or more of the preceding claims, **characterized in that** it comprises a framework (21) for supporting said container (10), an antenna (24) being arranged inside said container (10) and being inserted through a port (22) that is coaxial to the main axis (23) of said container (10), said antenna (24) acting as a cathode for a plasma generation device (25), which comprises a radiofrequency generator (25a), said container (10) acting as a reaction chamber for plasma deposition, said apparatus (10) comprising a device (32) for generating a vacuum inside said container (10) and means (26) for relative rotation between said antenna (24) and said container (10).

25. The apparatus according to claim 24, **characterized in that** said relative rotation means (26) are constituted by means (27) for the rotation of said container (10) on said antenna (24).

26. The apparatus according to claim 25, **characterized in that** said port (22) is connected by means of flanges (28) to a collar (29), which is fixed to said framework (21) and allows, for example by means of a system of sliding gaskets, a rotary connection to said container (10), said container (10) resting on free rollers of a lower supporting trolley (29a), said rotation means (27) being constituted by a motor drive (29b), which is connected kinematically for example by means of a toothed coupling to the region of said flanges (28).

27. The apparatus according to one or more of the preceding claims, **characterized in that** said antenna (24) is substantially as long as, or at the most slightly shorter than, the internal axial length of said container (10).

28. The apparatus according to one or more of the preceding claims, **characterized in that** said vacuum generation device (32) comprises pumping means (32a), which are functionally connected to the inside of said container (10).

29. The apparatus according to claim 28, **characterized in that** said pumping means (32a) respectively comprise in series a first suction pump (33), which is functionally connected to the inside of said container (10), and a second suction pump (34), a cryogenic trap (35) being arranged between said container (10) and said first suction pump (33).

30. The apparatus according to one or more of the preceding claims, **characterized in that** it comprises a device for treating the process gas (36) for the plasma deposition step, which comprises two electronically controlled MKS flowmeters, respectively a first flowmeter (37) and a second flowmeter (38), each of which is arranged on the respective connection channel for the reaction gas with the precursor, and for said precursor toward said antenna (24).

31. The apparatus according to one or more of the preceding claims, **characterized in that** it comprises said process gas treatment device (36) and further comprises an active head (39) for measuring the pressure.

32. The apparatus according to one or more of the preceding claims, **characterized in that** it comprises a device for depositing metals by evaporation (40).

33. The apparatus according to claim 32, **characterized in that** said device for depositing metals by evaporation (40) is of the sputter magnetron type for evaporating metals.

34. The apparatus according to claim 33, **characterized in that** it comprises a third suction pump (41), of the diffusion type, which is arranged between said first suction pump (33) and said cryogenic trap (35).

35. The apparatus according to claim 30 or to the subsequent claims, **characterized in that** the channel (42) for conveying the metal in gaseous form toward the inside of said container (10) of said metal deposition device (40), is integrated in said antenna (24).
